# EUROPEAN PATENT SPECIFICATION

(11) **EP 4 652 409 B1**
(45) Date of publication and mention of the grant of the patent: **22.04.2026**
(21) Application number: 24700300.7
(22) Date of filing: 11.01.2024
(51) Int. Cl.: F21V 29/508, F21V 29/85, H05K 7/20

(54) **SUSTAINABLE LED DRIVERS WITH IMPROVED THERMAL PERFORMANCE**
NACHHALTIGE LED-TREIBER MIT VERBESSERTER THERMISCHER LEISTUNG
PILOTES DE DEL DURABLES À PERFORMANCE THERMIQUE AMÉLIORÉE

(30) Priority: 17.01.2023 EP 23151920
(43) Date of publication of application: 26.11.2025
(73) Proprietor: Signify Holding B.V., 5656 AE Eindhoven (NL)
(72) Inventor: YU, Jiang, Hong, 5656 AE Eindhoven (NL); MARTIN, Genevieve, Therese, 5656 AE Eindhoven (NL)
(74) Representative: Verweij, Petronella Daniëlle
(86) International application number: PCT/EP2024/050589
(87) International publication number: WO 2024/153534

(56) References cited:
- WO-A1-2014/057035
- CN-A- 111 101 217
- JP-A- 2001 135 959
- JP-A- H06 268 113

## Description

### FIELD OF THE INVENTION

The invention relates to an electronic arrangement comprising an electrical arrangement and a thermal exchange material. The invention further relates to a light generating system comprising the electronic arrangement. The invention also relates to a method of assembly of the electronic arrangement.

### BACKGROUND OF THE INVENTION

The use of ultrahigh molecular weight polyethylene (UHMWPE) in combination with electronic devices is known in the art. For instance, WO2022082702A1 describes a multifunctional laminate and a portable electronic device comprising an ultrahigh molecular weight polyethylene (UHMWPE) sheet, and methods for making and using the multifunctional laminate in a portable electronic device.

### SUMMARY OF THE INVENTION

Light generating systems may be accompanied by electronic arrangements, for example drivers, to power and/or control the light generating systems. Electrical components comprised by these electronic arrangements may generate heat over the course of their operation. Operating such electrical components at high temperatures may reduce the lifespan of the electronic arrangement and may also affect their performance. Hence, it is desired to provide thermal management for such electrical components. To this end, e.g. a potting material may be applied. Thermal potting materials (that are typically applied to arrangements in liquid form prior to curing into solid form, for instance silicone-based materials with thermal conductive fillers or asphalt-based materials) and thermal interface materials (that are typically applied to arrangements in solid form, for example gap fillers) may e.g. be used to cool electrical components by guiding away heat. Such materials may typically have high thermal conductivity and may e.g. comprise epoxy, polyurethane, and/or a silicone compound. However, it may be challenging to remove potting materials and thermal interface materials as they may adhere to the electrical components. Therefore, these compounds and/or the (useful) electrical components may not be sustainable nor recyclable. Another cooling solution for electrical components may be thermal conductive pads. However, thermal conductive pads may be non-recyclable, heavy, and expensive.

It appears particularly desirable to provide a (more) sustainable cooling solution for electrical components. Hence, it is an aspect of the invention to provide an alternative electronic arrangement, which preferably further at least partly obviates one or more of above-described drawbacks. The present invention may have as object to overcome or ameliorate at least one of the disadvantages of the prior art, or to provide a useful alternative.

In a first aspect, the invention provides an electronic arrangement. The electronic arrangement especially comprises an electrical arrangement. The electronic arrangement further comprises a thermal exchange material. Especially, the electrical arrangement comprises a support. The electrical arrangement especially comprises a plurality of electrical components. The electrical components are especially supported by the support. According to the invention, the thermal exchange material comprises threads. The threads may in general be one or more threads. The threads further comprise a thermally conductive fibrous material. Especially, the thermally conductive fibrous material comprises ultra-high-molecular-weight polyethylene (UHMWPE) fibrous material (though other materials may also be possible; see also below). According to the invention, one or more of the threads may be configured in thermal contact with one or more parts of the electrical arrangement. The threads are in particular configured in thermal contact with at least one of the electrical components. Therefore, in specific embodiments the invention provides an electronic arrangement comprising an electrical arrangement and a thermal exchange material; wherein the electrical arrangement comprises a support and a plurality of electrical components supported by the support; wherein the thermal exchange material comprises one or more threads, wherein the one or more threads comprise a thermally conductive fibrous material, wherein the thermally conductive fibrous material comprises UHMWPE fibrous material; and wherein one or more of the one or more threads are configured in thermal contact with at least one of the electrical components.

With the present invention, the thermally conductive fibrous material, especially the UHMWPE fibrous material, may be in thermal contact with an electrical component and hence may facilitate the conduction of thermal energy (or: "heat") away from the electrical component. In particular, the thermal conductivity of the UHMWPE fibrous material may even be higher than the thermal conductivity of some known thermal potting materials and thermal interface materials. Hence, the cooling of the electrical components may be improved in the present invention. Further, the UHMWPE fibrous material may relatively easily be removed from electrical arrangement. The UHMWPE fibrous material may furthermore be suitable for recycling. The UHMWE fibrous material may therefore be a sustainable material, especially relative to typical thermal potting materials and thermal interface materials. Hence, the UHMWPE fibrous material may be a suitable and sustainable replacement for thermal potting materials and thermal interface materials. Further, this may also allow reuse of one or more of the electrical components, as they may not be embedded in adhering material that is difficult to remove from the electrical components, without damage of the electrical component(s). Such a thermal exchange material may be especially useful for electronic arrangements, such as e.g. for printed circuit boards (PCBs). The UHMWPE fibrous material may in the present invention be provided as threads. Such threads may be configured in various ways to be in thermal contact with the electrical components and another part of the electrical arrangement, such as e.g., wrapped around the electrical arrangement or covering one or more sides of the electrical arrangement. Therefore, the threads comprising the thermally conductive fibrous material may provide a (permanent) cooling solution of the electrical components as an integral part of the electronic arrangement. Additionally, the thermally conductive fibrous material may provide numerous protective benefits to the electronic arrangement. In specific embodiments, the thermally conductive fibrous material may provide electrical insulation, enhanced mechanical strength, flame retardancy, vibration/shock resistance, corrosion protection, chemical protection, and/or environmental influence protection. The use of the threads of fibrous material may also provide a relatively light weight potting material. Thereby, the electronic arrangement may be well-protected from both external and internal hazards. Such an electronic arrangement may be especially useful for outdoor applications, such as e.g. for light emitting diode (LED) drivers in outdoor lighting systems. Hence, the present invention may in particular provide sustainable LED drivers with improved thermal performance.

As indicated, in embodiments, the invention provides an electronic arrangement comprising an electrical arrangement and a thermal exchange material. Embodiments will further be described below.

The electrical arrangement may in embodiments comprise a support. Especially, the support may comprise a structure supporting other components of the electrical arrangement. Such components may in general be coupled to and/or configured on the support. The support may in embodiments comprise one or more structural elements, especially a board. In certain embodiments, the support may comprise a PCB (further described below). Yet, in embodiments, the support may comprise a main support and the printed circuit board, which may be functionally coupled to the main support. The main support may be provided by a housing or may be functionally coupled to the housing (and essentially enclosed by the housing).

Especially, the support may be a structure upon which other elements may be coupled to or configured on. Furthermore, in embodiments, the support arrangement may comprise a plurality of electrical components functionally coupled to the support. Hence, the support may especially have features to accommodate the aforementioned electrical components. For instance, the support may comprise ports to connect to the electrical components. Especially, the electrical components may comprise electrodes or nodes which may be functionally coupled to the support. Here, functionally coupled may refer to securing the electrical components to the support such that the electrical components are secured in place with substantially no relative motion between the support and the electrical components. In embodiments, the electrical components may be electrically coupled to the support. That is, the electrical components may especially be connected to other electrical components via the support. Hence, alternatively or additionally, functionally coupled may refer to electrical contact of the electrical component with one or more electrically conductive tracks comprised by the support. Further, the electrical components may especially be connected to a power source via the support. In some embodiments, the power source may be configured on the support. However, alternatively the power source may in embodiments also be configured external to the support.

In embodiments, the support arrangement may comprise a printed circuit board (PCB). Especially, the printed circuit board may be functionally coupled to the support. Further, in embodiments, the electrical components may be electrically coupled to the printed circuit board.

As known in the art, a printed circuit board ("PCB" or "board") may mechanically support and electrically connect electronic components or electrical components using electrically conductive tracks, pads and other features etched from one or more sheet layers of copper laminated onto and/or between sheet layers of a non-conductive substrate (shortly indicated as "track" or "conductive track"); though other options may also be possible.

A PCB may comprise one or more electrically conductive tracks, which may e.g. comprise copper. When there are two or more electrically conductive tracks, two or more tracks may be electrically isolated from each other. In embodiments, two or more electrically conductive tracks may be electrically isolated from each other, but be (temporarily) electrically connected to each other via one or more electrical component. The electrical connection may be temporary, when e.g. during operation a switch opens or closes an electrical connection. An electrical connection may e.g. be permanent, when e.g. an electrical component is configured electrically connected to two electrically conductive tracks.

Hence, in embodiments a PCB may comprise an insulating layer arranged between a substrate and a conductive layer.

An (electronic) component, such as a solid stage light source, may generally be soldered onto the PCB to both electrically connect and mechanically fasten it to the PCB. For instance, a basic PCB may consist of a flat sheet of insulating material and a layer of copper foil, laminated to the substrate. Chemical etching divides the copper into separate conducting lines called tracks or circuit traces, pads for connections, vias to pass connections between layers of copper, and features such as solid conductive areas for EM shielding or other purposes. The tracks function as wires fixed in place, and are insulated from each other by air and the board substrate material. The surface of a PCB may have a coating that protects the copper from corrosion and reduces the chances of solder shorts between traces or undesired electrical contact with stray bare wires. For its function in helping to prevent solder shorts, the coating is called solder resist.

Hence, the shape of a PCB may in general be plate-like. Especially, in embodiments the PCB may have a length and a width and a height, wherein an aspect ratio of the length and the height is at least 5, like in the range of 5-5000, like 10-2500, and wherein an aspect ratio of the width and the height is at least 2, such as an aspect ratio of at least 5, like in the range of 5-5000, like 10-2500. The terms "length", "width", and "height" may also refer to "largest length", "largest width", and "largest height", respectively. The PCB may especially have a rectangular cross-section (such as a square cross-section).

The height (or thickness) of the PCB may in embodiments be selected from the range of 0.2-10 mm, such as 0.5-5 mm, like 1-2 mm. The width of the PCB may in embodiments be selected from the range of 5-200 mm, such as 5-50 mm. The length of a single printed circuit board area may in embodiments e.g. be selected from the range of 10-50 mm, such as 15-40 mm. The length of the PCB, including a plurality of (connected) PCB areas, may in embodiments e.g. be selected from the range of 20-2000 mm, such as 20-1500 mm. Other dimensions may be possible as well.

In further embodiments, the functional component may comprise an electronic component, especially an electronic component selected from the group comprising a solid state light source, a driver, an electronic module, or a sensor. Especially, the electronic component may comprise a solid state light source.

In embodiments, the board may comprise a rigid board or a semi-rigid board, especially a rigid board. In other embodiments, the board may comprise a semi-rigid board. In specific embodiments, the printed circuit may be flexible. In yet other embodiments, the printed circuit board may be rigid.

In embodiments, the board may comprise a metal, especially a metal selected from the group comprising copper aluminum, tin, iron, silver and lead, more especially a metal selected from the group comprising copper and aluminum.

In further embodiments, the (printed circuit) board may have a thermal conductivity of at least 0.2 W/(m*K), especially at least 2 W/(m*K), such as at least 20 W/(m*K). The (printed circuit) board may further have a thermal conductivity of up to 400 W/(m*K), especially up to 350 W/(m*K), such as up to 300 W/(m*K). Thereby the (printed circuit) board may have a thermal conductivity selected from the range of 0.2 - 400 W/(m*K), especially from the range of 2 - 350 W/(m*K), such as from the range of 20 - 300 W/(m*K). Instead of "W/m*K" also the indications W/mK or W.m⁻¹.K⁻¹ may be applied.

In specific embodiments, the board may comprise a printed circuit board. Especially, the board may comprise one or more of a CEM-1 PCE, a CEM-3 PCE, a FR-1 PCE, a FR-2 PCB, a FR-3 PCB, a FR-4 PCB, and aluminum metal core PCB, especially one or more of a CEM-1 PCB, a CEM-3 PCB, a FR-1 PCB, and a FR4 PCB and an aluminum metal core PCB, more especially one or more of a CEM-1 PCB, a CEM-3 PCB, a FR-1 PCB.

In embodiments the printed circuit board comprises a thermally conductive material, such as aluminum. Printed circuit boards comprising a metal core may also be indicated as insulated metal substrate (IMS).

Especially, the support is a rigid support, such as a conventional PCB.

In embodiments, an electrical component may be a component that (directly) converts the energy from an electrical current into another form of energy, e.g., heat, light, motion, etc. Further, in embodiments an electrical component may control the flow of electrons from an electrical current. Yet, in embodiments an electronic component may comprise a (basic) discrete device or physical entity in an electronic system used to affect electrons or their associated fields. Herein, the term electrical component may especially refer to an electronic component. The electronic component may include an active or a passive electronic component. In embodiments, the electronic component may comprise a sub-PCB board (or additional PCB board) comprising one or more electronic components. An active electronic component may be any type of circuit component with the ability to electrically control electron flow (electricity controlling electricity). Examples thereof are diodes, especially light emitting diodes (LED). LEDs are herein also indicated with the more general term solid state lighting devices or solid state light sources. Hence, in embodiments the electronic component comprises an active electronic component. Especially, the electronic component comprises a solid state light source. Other examples of active electronic components may include power sources, such as a battery, a piezo-electric device, an integrated circuit (IC), and a transistor. In embodiments, the electronic component comprises a driver. In yet other embodiments, the electronic component may include a passive electronic component. Components incapable of controlling current by means of another electrical signal are called passive devices. Resistors, capacitors, inductors, transformers, etc. can be considered passive devices. In embodiments, the electronic component may include an RFID (Radio-frequency identification) chip. A RFID chip may be passive or active. Especially, the electronic component may include one or more of a solid state light source (such as an LED), a RFID chip, and an IC. The term "electronic component" may also refer to a plurality of alike or a plurality of different electronic components. In embodiments, the support arrangement may comprise at least three, more especially at least four, such as at least 10 electrical components. In embodiments, the electrical components may at least comprise one or more ICs and one or more resistors.

Such electrical component may e.g. comprise a capacitor, an inductor, a voltage regulator, an amplifier circuit, an integrated circuit, a central processing unit, a microprocessor unit, a power transistor, a field-effect transistor ("FET", especially a metal-oxide semiconductor field-effect transistor ("MOS-FET")), a transformer, a resistor, or a diode. Moreover, electrical components may e.g. comprise a capacitor, a resistor, a (crystal) diode, or a sensor. In embodiments comprising a PCB, the electrical components may be functionally and electrically coupled to the PCB. In embodiments, the one or more electrical components are selected from the group comprising a capacitor, an inductor, a voltage regulator, an amplifier circuit, an integrated circuit, a central processing unit, a microprocessor unit, a power transistor, a field-effect transistor, a transformer, a resistor, a diode, and a sensor.

Thereby, in embodiments, the electrical arrangement comprises a support and a plurality of electrical components supported by the support. Especially, in embodiments, the support comprises a printed circuit board, wherein the electrical components are electrically coupled to the printed circuit board.

The thermal exchange material may be a material that transfers heat from a hotter item to a cooler item and/or to air. The thermal exchange material may thus especially a thermally conductive material. A thermally conductive material may especially have a thermal conductivity of at least about 20 W/(m*K), like at least about 30 W/(m*K), such as at least about 100 W/(m*K), like especially at least about 200 W/(m*K). In yet further specific embodiments, a thermally conductive material may especially have a thermal conductivity of at least about 10 W/(m*K). However, lower thermal conductivities may also be usable to transfer heat away.

The thermal exchange material may in embodiments comprise threads. In general, the thermal exchange material may comprise one or more threads. The term "thread" may especially refer to a macroscopic thread, and not to the (microscopic) fibers from which it may essentially consist of (see also below). Therefore, herein the phrase "the one or more threads comprise a thermally conductive fibrous material", and similar phrases, is applied.

The term thread may herein refer to an elongated flexible material body having a length that is longer than the circular equivalent cross-sectional diameter. Herein, instead of the term "circular equivalent cross-sectional diameter" in relation to the threads, also the term "thread diameter" is applied (see also below).

Such thread may have a length that is at least 10 times larger, such as at least 1E2 times larger than the circular equivalent cross-sectional diameter. In embodiments, such thread may have a length that is at least at least 1E3 times longer, especially at least 1E4 times longer. In general, the circular equivalent cross-sectional diameter will be substantially the same over the length of the thread. The threads may have length selected from the range of 0.5 mm - 100 m. Larger thread lengths are herein not excluded. The length of the threads may depend upon the type of threads that are used. Herein, different type of threads are applied (see also below), such as rope-like or (rock)wool-like.

The equivalent circular diameter (or ECD) (or "circular equivalent diameter") of an (irregularly shaped) two-dimensional shape is the diameter of a circle of equivalent area. For instance, the equivalent circular diameter of a square with side a is 2*a*SQRT(1/π). For a circle, the diameter is the same as the equivalent circular diameter. Would a circle in an xy-plane with a diameter D be distorted to any other shape (in the xy-plane), without changing the area size, than the equivalent circular diameter of that shape would be D.

As can be derived from the above, the one or more threads may comprise a fibrous material. Further, in embodiments, the fibrous material may be selected to be thermally conductive. Hence, the one or more threads may comprise a thermally conductive fibrous material.

In embodiments, the thermally conductive fibrous material may comprise a (linear) polymeric material, comprising polymer chains of repeating units. A single polymer chain may herein be referred to as a "fiber" (also: "chain" or "strand. )A thread of the thermal exchange material may in specific embodiments thereby comprise a plurality of fibers.

The thermally conductive fibrous material may comprise a natural fibrous material or a synthetic fibrous material. A natural fibrous material is sourced (directly) from a living organism, e.g., cotton, silk, wool, etc. A synthetic fibrous material may be sourced from chemical synthesis of fibers, e.g., polyethylene (PE), nylon, polyvinyl chloride (PVC), polyethylene terephthalate (also "polyester" or "PET"), etc. In general, a synthetic fibrous material may have a higher thermal conductivity than a natural fibrous material. A synthetic fibrous material may thereby be preferrable in the present invention. Hence, in embodiments, the thermally conductive fibrous material comprises a synthetic fibrous material. Such synthetic fibrous material may in general be selected from the group comprising UHMWPE, polyimide, polymethyl methacrylate (PMMA), nylon, epoxy/glass fiber, and a fiber coated with a graphene layer. Further, such (synthetic) thermal conductive fibrous material may be selected to be a dielectric material, i.e., an electrically insulating material.

Especially, such (synthetic) thermally conductive fibrous material may have an (in-plane) thermal conductivity of at least 0.05 W/mK, such as at least 0.2 W/mK, especially at least 1 W/mK. The (synthetic) thermally conductive fibrous material may have an (in-plane) thermal conductivity of up to 50 W/mK, such as up to 30 W/mK, especially up to 30 W/mK. Thereby, the (synthetic) thermally conductive fibrous material may have an (in-plane) thermal conductivity selected from the range of 0.05 - 50 W/mK, such as from the range of 0.2 - 30 W/mK, especially from the range of 1 - 30 W/mK. Hence, the thermal exchange material may be an effective conductor of heat.

Further, such (synthetic) thermally conductive fibrous material may have a dielectric strength of at least 1 kV/cm³, such as at least 10 kV/cm³, especially at least 100 kV/cm³. The (synthetic) thermally conductive fibrous material may have a dielectric strength of up to 2000 kV/cm³, such as up to 1500 kV/cm³, especially up to 1000 kV/cm³. Thereby, the (synthetic) thermally conductive fibrous material may have a dielectric strength selected from the range of 1 - 2000 kV/cm³, such as from the range of 10 - 1500 kV/cm³, especially from the range of 100 - 1000 kV/cm³. Hence, the (synthetic) thermally conductive fibrous material may be selected to provide relatively high electric insulation and may be safe for use in an electronic arrangement such as described herein.

In embodiments, the thermally conductive fibrous material may comprise UHMWPE fibrous material. UHMWPE is a thermoplastic material. More specifically, UHMWPE is a polyolefin material based on PE. Relative to other PE-based materials, UHMWPE is characterized by particularly long linear polymer chains of at least 20,000 repeating units, such as at least 25,000 repeating units, especially at least 30,000 repeating units. Further, UHMPWE polymer chains may have up to 200,000 repeating units, such as 150,000 repeating units, especially 120,000 repeating units.

Hence, the thermally conductive fibrous material may comprise polyethylene (PE) polymer chains. Especially, the thermally conductive fibrous material may comprise ultra-high-molecular-weight-polyethylene (UHMWPE). The polymer chains of UHMWPE have a particularly high molecular weight (i.e., an ultra-high molecular weight) relative to other PE-based materials due to the length of their polymer chains. The PE polymer chains (of UHMWPE) may have a molecular weight of at least 5E5 Da, such as of at least 1E6 Da, especially at least 2E6 Da. Further, the PE polymer chains (of UHMWPE) may have a molecular weight of up to 2E7 Da, such as up to 1E7, especially up to 5E6 Da. In certain embodiments, the thermally conductive fibrous material may especially comprise PE polymer chains with a molecular weight selected from the range of 1E6 - 1E7 Da.

In general, UHMWPE may be synthesized such that the PE polymer chains are aligned in the same direction. As such, the PE polymer chains (of UHMWPE) may have a fiber orientation of at least 65%, such as 75%, especially 85%. Further, the PE polymer chains (of UHMWPE) may have a fiber orientation of up to 99%, such as 95%, especially 90%. In specific embodiments, the thermally conductive fibrous material may especially comprise PE polymer chains with a fiber orientation selected from the range of 75 - 95%.

Further, the PE polymer chains of UHMWPE may have a fiber diameter. The PE polymer chains (of UHMWPE) may have a fiber diameter of at least 0.98 nm, such as at least 50 nm, especially at least 2000 nm. The PE polymer chains (of UHMWPE) may have a fiber diameter of up to 1E6 nm, such as up to nm, especially up to 50,000 nm. In some embodiments, the thermally conductive material may especially comprise PE polymer chains with a fiber diameter selected from the range of 0.98 - 1E6 nm.

UHMWPE has particularly suitable thermal conductivity properties for the present invention. The PE polymer chains (of UHMWPE) may especially have an (in-plane) thermal conductivity of at least 6 W/mK, such as at least 10 W/mK, especially at least 12 W/mK. The PE polymer chains (of UHMWPE) may have an (in-plane) thermal conductivity of up to 30 W/mK, such as up to 28 W/mK, especially up to 25 W/mK. In certain embodiments, the thermally conductive material may especially comprise PE polymer chains with an (in-plane) thermal conductivity selected from the range of 10 - 30 W/mK. Thereby, the thermal conductivity of UHMWPE may be higher relative to the thermal conductivity of typical thermal potting materials and thermal interface materials, which may for example be in general in the range of 1 - 6 W/mK. Hence, UHMWPE may be particularly suitable for the present invention due to its capacity for thermal exchange.

An example of UHMWPE is e.g. Dyneema^{®} UHMWPE, which may have an axial (or in-plane) thermal conductivity of 20 W/mK (and transverse thermal conductivity of 0.2 W/mK). Specific examples are e.g. Dyneema^{®} SK78, SK75, SK65, SK62, SK60, or SK25. However, other embodiments may also be possible.

Further, UHMWPE fibrous material may be light-weight, i.e., have a low density relative to other thermal potting materials and thermal interface materials. The PE polymer chains (of UHMWPE) may have a density of at least 0.1 g/cm³, such as 0.2 g/cm³, especially 0.5 g/cm³. The PE polymer chains (of UHMWPE) may have a density of up to 20 g/cm³, such as 10 g/cm³, especially 5 g/cm³. In some embodiments, the PE polymer chains (of UHMWPE) may have a density selected from the range of 0.5 - 5 g/cm³. Thereby, the thermally conductive fibrous material may be relatively light-weight, improving the applicability in electronic arrangements by not contributing further mechanical stress to the arrangement.

Therefore, in embodiments, the thermally conductive fibrous material comprises polyethylene polymer chains with a molecular weight selected from the range of 1E6 - 1E7 Da, having a fiber orientation selected from the range of 75 - 95%, having a fiber diameter selected from the range of 0.98 - 1E6 nm, having an (in-plane) thermal conductivity selected from the range of 10 - 30 W/mK, and having a density selected from the range of 0.5 - 5 g/cm³.

UHMPWE fibrous material may have a variety of properties, e.g. in terms of density and thermal conductivity, that make UHMPWE fibrous material particularly suitable as a thermal exchange material relative to typical thermal potting materials, thermal interface materials, and other fibrous materials. Further, UHMPWE fibrous material may have low adhesion to other materials relative to typical thermal potting materials, and other fibrous materials. Thereby, the UHMPWE fibrous material may be readily removed from an electronic arrangement such as described herein. UHMPWE fibrous material may further be recycled and used in further applications as reprocessed UHMPWE material. Hence, UHMWPE fibrous material may further be a sustainable material relative to typical potting materials, thermal interface materials, and other fibrous materials.

Therefore, in embodiments, the thermal exchange material comprises one or more threads, wherein the one or more threads comprise a thermally conductive fibrous material, and wherein the thermally conductive fibrous material comprises UHMWPE fibrous material.

Different electrical components and different functional activities may generate heat at different rates. The increase in temperature (or: "production of heat") of the electrical component may be at least 10 °C, such as by at least 30 °C, especially by at least 50 °C. Further, the increase in temperature of the electrical component may be up to 80 ° C, such as up to 100 °C, especially up to 120 °C. Some electrical components and functional activities may not result in a (substantial) increase in temperature of the electrical component. The increase in temperature of the electrical component may thus be (essentially) 0 °C, such as 0.1 °C, especially 1 °C. Therefor the increase in temperature of an electrical component may depend on the type of electrical component and the type of functional activity it performs. The temperature of an electrical component may further be affected by temperature increases caused by another electrical component and functional activity in direct physical contact or in close proximity (e.g., within 100 µm, especially within 1 mm). Therefore, in embodiments, the thermal exchange material may be configured to lead heat away from the electrical arrangement, especially from electrical components. This may be facilitated by configuring the one or more threads in thermal contact with an electrical component, especially with at least one of the electrical components.

An element may be considered in "thermal contact" with another element if it can exchange thermal energy. Thereby, the elements may be thermally coupled. In embodiments, thermal contact can be achieved by direct physical contact between two elements. Thermal contact may also be achieved between two elements when the two elements are arranged relative to each other at a distance of equal to or less than about 10 µm, though larger distances, such as up to 100 µm may be possible. The shorter the distance, the better the thermal contact. Especially, the distance may be 10 µm or less, such as 5 µm or less, especially 1 µm or less. The distance may be the measured between two respective surfaces of the respective elements. The distance may be an average distance. For instance, the two elements may be in physical contact at one or more, such as a plurality of positions, but at one or more, especially a plurality of other positions, the elements are not in physical contact. For instance, this may be the case when one or both elements have a rough surface. Hence, in embodiments in average the distance between the two elements may be 10 µm or less (though larger average distances may be possible, such as up to 100 µm).

By configuring the one or more threads (with high thermal conductivity) in thermal contact with at least one of the electrical components, heat may be guided away effectively from the at least one of the electrical components. In embodiments, heat from the at least one of the electrical components may be absorbed by the thermal exchange material. Further, heat from the at least one of the electrical components may be exchanged with another material (and/or air) that is in thermal contact with the thermal exchange material. For example, heat may be exchanged with ambient air surrounding the thermal exchange material. Furthermore, in certain embodiments, the one or more threads may be configured in thermal contact with another part of the electrical arrangement, e.g., the support or another electrical component (operating at a lower temperature. Thus the heat from the at least one of the electrical components may be guided away to other elements of the electric arrangement. Hence, the thermal exchange material facilitates safe, effective and durable operation of the electronic arrangement by providing thermal exchange of heat away from electrical components. Further, herein the phrase "one or more threads in thermal contact with at least one of the electrical components", and similar phrases, may in embodiments especially refer to one or more threads in physical contact with at least one of the electrical components. Thereby, in embodiments, the one or more threads are configured in thermal contact with at least one of the electrical components.

In embodiments, the one or more threads may be configured in a variety of configurations. The configuration may be selected to increase thermal contact between the thermal exchange material and the electrical components. Further, the configuration may be selected to increase thermal contact between the thermal exchange material and elements. Moreover, the configuration may be selected to improve ease of application and reduce the required amount of thermal exchange material in the electronic arrangement. Furthermore, the configuration may be selected to provide one or more of further potential benefits to the electronic arrangement, e.g., electrical insulation, enhanced mechanical strength, flame retardancy, vibration/shock resistance, corrosion protection, chemical protection, and/or environmental influence protection. Hence, in specific embodiments, the thermally conductive fibrous material may be flame-retardant. In some embodiments, the thermally conductive fibrous material may intrinsically be flame-retardant. In other embodiments, the thermally conductive fibrous material may be coated with a flame-retardant coating, such as coatings comprising boron compounds, mineral acids, and/or inorganic salts. Thus the thermally conductive fibrous material may provide flame-retardant filaments. Hence, the thermally conductive fibrous material provides flame-retardant protection to the electronic arrangement.

In certain embodiments, the configuration may comprise at least one of the one or more threads being wound around the electrical arrangement. The at least one or more threads may in embodiments refer to a single thread wound one or more times, especially a plurality of times, around the electrical arrangement, or may refer to two or more, such as e.g. selected from the range of 2-50 threads, with each wound one or more times around the electrical arrangement.

Hence, the at least one thread may be wound around the electrical arrangement such that the at least one thread is in thermal contact with at least one of the electrical components. The at least one thread may have one or more contact points with the electrical arrangement. More especially, the at least one thread may have at least one or more contacts points with at least one of the electrical components. Further, the at least one thread may be in thermal contact with another part of the electrical arrangement, such as the support or another electrical component (which may e.g. operate at a lower temperature). The electrical arrangement, and especially the one or more electrical components thereupon, may be designed such that the at least one thread may be in thermal contact with the one or more electrical components by being wound around the electrical arrangement. Therefore, in embodiments, at least one of the one or more threads is wound around the electrical arrangement.

In specific embodiments, the configuration may comprise at least one of the one or more threads being wound a plurality of times around the electrical arrangement. The plurality of times that the at least one of the one or more threads is wound around the electrical arrangement may be at least 2 times, such as at least 5 times, especially at least 10 times. The at least one thread may be wound around the electrical arrangement such that the at least one thread is in thermal contact with at least one of the electrical components. Further, the at least one thread may be wound around the electrical arrangement such that the at least one thread is in thermal contact with a plurality of electrical components, such as at least 2 electrical components, especially at least 5 electrical components. In some embodiments, the at least one thread may be in thermal contact with the same plurality of electrical components for each of the plurality of times. In other embodiments, the at least one thread may be in thermal contact with different electrical components from the plurality of electrical components at least two times. Further, the at least one thread may be wound around the electrical arrangement such that the at least one thread is in thermal contact with another part of the electrical arrangement, especially the support. In certain embodiments, the at least one thread may be in thermal contact with the same part of the electrical arrangement for each of the plurality of times. In further embodiments, the at least one thread may be in thermal contact with different parts of the electrical arrangement components for at least two of the plurality of times. The electrical arrangement, and especially the one or more electrical components thereupon, may be designed such that the at least one thread may be in thermal contact with the one or more electrical components by being wound around the electrical arrangement a plurality of times. For instance, the arrangement of the electrical components on the support may depend upon the height of the components. In this way, thermal contact may be maximized.

Especially, winding the one or more threads a plurality of times may provide more efficient thermal exchange with a larger number of electrical components. Further, such configuration may be particularly easily adjusted for different electrical arrangements as the one or more threads may be wound in one or more different directions from the at least one of the electrical components. Thereby the thermal exchange may be directed from a number of different electrical components towards specific parts of the electrical arrangement. Furthermore, such configuration may be a particularly stable configuration of the one or more threads. Thereby, in embodiments, at least one of the one or more threads is wound a plurality of times around the electrical arrangement.

In some embodiments, one or more threads may be configured to cover one or more electrical components. The one or more threads may in particular be configured to at least partly cover one or more electrical components.

In embodiments, one or more threads may be wound around the electrical arrangement. Further, in embodiments one or more threads may (also) be wound around an electrical component.

In a specific type of embodiments, the one or more threads may comprise at least two threads arranged essentially in parallel so as to compose a sheet-like formation that may be overlayed over the one or more, especially a plurality of, electrical components. Such sheet-like formation may (essentially) provide a two-dimensional surface with a thickness of at least one single fiber, such as at least two single fibers, especially at least five single fibers. With such configuration, the one or more threads may be in thermal contact with the one or more electrical components. Hence, the one or more threads may effectively guide heat away from the electrical component via (at least partly) covering the electrical component. Additionally or alternatively, one or more threads may be configured between two or more electrical components. Especially, one or more threads may be configured in thermal contact with one or more electrical components. One or more threads may be in direct physical contact of the side of one or more electrical components without covering said one or more electrical components. For example, one or more threads may be wound around the side of the one or more electrical components. Alternatively, one or more threads may be stretched along the side of the one or more electrical components. In specific embodiments, one or more threads may be configured with the two or more electrical components. Hence, such configuration may facilitate guiding heat away from the electrical component without covering the electrical component. Of course, combination of embodiments may be applied. Therefore, in embodiments, one or more of the following applies: (i) one or more threads cover at least part of one or more electrical components and are in thermal contact with these one or more electrical components, and (ii) one or more threads are configured between two or more electrical components, and are in thermal contact with one or more electrical components.

The electronic arrangement may in specific embodiments comprise at least three electrical components, such as at least five electrical components, especially at least ten electrical components. A subset of the at least three electrical components may comprise at least three electrical components, such as at least four electrical components, especially at least five electrical components. The electrical components of said subset may be configured such that at least one thread of the one or more threads is in thermal contact with all the electrical components of the subset. In particular, said at least one thread may be wound at least one time around the electrical arrangement, such as at least two times, especially at least five times. The at least one thread may at least partly cover one or more of the subsets of electrical components. Further, the at least one thread may (essentially) entirely cover one or more of the subsets of electrical components. Alternatively or additionally, the at least one thread may be wound around one or more of the subset of electrical components. Furthermore, the at least one thread may be stretched around the side of the one or more of the subset of electrical components. In some embodiments, the at least one thread may be wound one or more times around the electrical arrangement, thereby being in thermal contact with all the electrical components of the subset each time. In other embodiments, the at least one thread may be wound a plurality of times around the electrical arrangement, being in thermal contact with a different electrical components of the subset for at least two times. Hence, such configurations may provide one or more threads effectively guiding heat away from a plurality of electrical components. Thereby, in embodiments, the electronic arrangement comprising at least three electrical components, wherein a subset of the at least three electrical components comprise at least three electrical components, wherein the electrical components of the subset are configured such that at least one thread wound at least one time around the electrical arrangement is configured in thermal contact with all the electrical components of the subset.

The one or more threads may be defined by a thread diameter d₁. Such thread diameter d₁ may refer to a cross-sectional diameter of the one or more threads. As indicated above, herein, different type of threads may be applied (see also below), such as rope-like or (rock)wool-like. In general, the former may have a larger thread diameter than the former.

Especially, each of the one or more threads may comprise a one or more, especially a plurality of, fibers of the thermally conductive fibrous material. Hence, in embodiments the thread diameter may be larger than the fiber diameter. The thread diameter d₁ may be at least 0.001 mm, such as at least 0.005 mm, especially at least 0.01 mm. The thread diameter d₁ may be up to 100 mm, such as up to 50 mm, especially up to 10 mm. Thus, the thread diameter may be selected from the range of 0.001 - 100 mm, such as from the range of 0.005 - 50 mm, especially from the range of 0.01 - 10 mm. Note that the tread diameters may differ amongst threads.

Therefore, in embodiments, the one or more threads may have a thread diameter d₁ selected from the range of 0.01 - 10 mm. Especially, in embodiments the one or more threads may have a thread diameter d₁ selected from the range of 0.5 - 10 mm. Such threads may have a rope-like character, and may e.g. be used to wind around the electrical components and/or the electrical arrangement. For flexibility reasons, especially the thread diameter d₁ selected from the range of 0.5 - 5 mm.

In other embodiments, the one or more threads may have a (rock)wool like character or fluff wool character, herein (both) indicated a (rock)wool like character. In such embodiments, the one or more of the threads may have a plurality of turns. Such threads may not easily be wound wind around the electrical components and/or the electrical arrangement but may be provided as fluffy package of one or more threads, like unspun wool lost by a sheep.

In yet further embodiments, the thermal exchange material may comprise at least two threads. The at least two threads may be configured such that (i) at least one thread has a rope-like character and (ii) at least one other thread has a wool-type character. The at least one thread with a rope-like character may especially be wound around at least part of the electrical arrangement. Thus the at least one thread with a rope-like character may be in thermal contact with one or more electrical components. The at least one other thread with a wool-type character may in particular be configured to cover at least part of one or more electrical components. Thereby the at least one thread with a wool-type character may be in thermal contact with one or more electrical components. In some embodiments, the at least one thread with a rope-like character and at least one other thread with a wool-type character may be configured to be in thermal contact with different electrical components. In other embodiments, the one thread with a rope-like character and at least one other thread with a wool-type character may be configured to be in thermal contact with (partially) overlapping subsets of electrical components.

In such embodiments, the one or more threads may be provided with a plurality of turns. The plurality of turns may be at least 5 turns, such as at least 10 turns, though more turns may also be possible. A turn may be defined as a (substantial) change in direction of the one or more threads. In embodiments, a turn may be an acute turn or an obtuse turn. A turn may be curved. A turn may be indicated with a (turn) radius r₁. The radius r₁ may in embodiments be at least 0.2*d₁, such as at least 0.5*di, especially at least d₁. The radius r₁ may in embodiments be up to 100 mm, such as up to 50 mm, especially up to 18 mm. Thus, in embodiments the radius r₁ may be selected from the range of 0.2*d₁- 100 mm, such as from the range of 0.5*di- 50 mm, especially from the range of d₁ - 18 mm. Hence, the one or more threads may be provided in thermal contact with a surface of the one or more electrical components, especially with a surface of the support. Such one or more threads may be particularly effective for a homogenous dispersal of heat away from the electrical components to ambient air and other parts of the electronic arrangement. Further, such one or more threads may be easily applicable. Thereby, in embodiments, one or more threads are provided with a plurality of turns, wherein one or more threads have thread diameters selected from the range of 0.01 - 0.5 mm, and wherein the turns have radii r₁ selected from the range of d1 -18 mm. More especially, one or more threads are provided with each at least five of turns, wherein one or more threads have thread diameters selected from the range of 0.01 - 0.5 mm, and wherein the turns have radii r₁ selected from the range of d1 -18 mm. Such relatively flexible threads may be provided as packages of (rock)wool type material, which may be arranged between electrical components and/or which may be in thermal contact with the support. Hence, a plurality of turns may intertwine with each other, i.e., a first turn may later be crossed by another turn. Thereby, the one or more threads may be configured as a volume of intertwined turns, especially intertwined curves. For example, the one or more threads may be provided as a hank of threads, a coil of threads, a skein of threads, a tangle of threads, etc. In some embodiments, each of the one or more threads may comprise a plurality of fibers of the thermally conductive fibrous material. More especially, each of the one or more threads may comprise one single fiber of the thermally conductive fibrous material. The thread diameter d₁ (in these embodiments) may be at least 0.001 mm, such as at least 0.005 mm, especially at least 0.01 mm. The thread diameter d1 may be up to 5 mm, but in generally smaller, such as up to 1 mm, more especially up to 0.5 mm. Thus, the thread diameter may be selected from the range of 0.001 - 5 mm, such as from the range of 0.005 - 1 mm, especially from the range of 0.005 - 0.5 mm, like e.g. selected from the range of 0.01 - 0.5 mm.

Especially, the support may comprise a first face and a second face. Especially, the first face and the second face may face in opposite directions. The plurality of electrical components may be configured at the first face. In certain embodiments, additionally one or more electrical components may be configured at the second face. In other embodiments, no electrical components may be configured at the second face. Hence, the one or more threads may be especially configured to be in thermal contact with at least part of the first face. Therefore, in embodiments, the support comprises a first face and a second face, wherein the plurality of electrical components may be configured at the first face. Especially, as indicated above, the support may comprise a PCB, wherein the first face is a top face, and the second face is a back face of the PCB, with most, especially essentially all, electrical components configured at the side of the first face and configured on the first face.

The electronic arrangement may further comprise a frame structure. Such frame structure may be especially configured at the second face. The frame structure may comprise a structural element. More especially, the structural element may comprise one or more openings. The one or more openings may be arranged in the structural element such that the one or more openings face the support, especially the second face of the support. The one or more openings may especially be through openings extending from a first side of the structural element (facing the support) to another side of the structural element. Yet, in some embodiments, the one or more openings may be cavities in the structural element facing the support. In embodiments, the structural element may have a cross-sectional area essentially the same as the cross-sectional area of the support, such as the cross-sectional area of a PCB. Hence, the structural element may in embodiments also be configured as support for the support. Further, the structural element allows, due to the presence of the openings, arrangement of threads therein, especially the (rock)wool type of threads. The structural element may have a height selected from the range of about 1 - 20 mm. The openings may have cross-section equivalent diameters selected from the range of about 5 - 500 mm. The openings may be defined by a width selected from the range of 1 - 100 mm, such as 2 - 75 mm. The openings may further be defined by a length selected from the range of 1 - 100 mm such as 2 - 75 mm. The openings may also have circular (or otherwise shaped) cross-sectional shapes, instead of rectangular shapes.

The structural element may especially be comprised of materials that are thermally conductive, having (in-plane) thermal conductivity of at least 0.05 W/mK, such as at least 0.2 W/mK, especially at least 1 W/mK. Further, the structural element may comprise materials that are electrically insulating, having a dielectric strength of at least 1 kV/cm³, such as at least 10 kV/cm³, especially at least 100 kV/cm³. Moreover, the structural element may provide mechanical strength to the electronic arrangement, having a tensile strength of at least 50 MPa, such as at least 100 MPa, especially at least 200 MPa. As such, the structural element may especially be selected from materials such as ceramics, glass, silicone, epoxy, or polymer. In embodiments, the structural element may comprise a highly filled hexagonal boron nitride ((in-plane) thermal conductivity of 400 W/mK) organic polymer or silicone. In embodiments, the structural element may comprise a ceramic bar, for example aluminum nitride ("AlN") or aluminum oxide ("AlO"). In embodiments, the structural element may comprise a metal, such as aluminum. Especially, the structural element comprised of metal may be coated with an electrically insulating coating. Hence, the frame structure may provide additional mechanical strength and further thermal conductivity to the electronic arrangement. Further, the frame structure may be electrically insulating to ensure safe and appropriate functioning of the electronic arrangement. Thereby, in embodiments, the electronic arrangement further comprises a frame structure, configured at the second face, wherein the frame structure comprises a structural element, further comprising one or more openings facing the support.

As indicated above, the one or more openings may provide a space to host the one or more threads. Especially, the one or more threads may be configured in one or more of the one or more openings. The one or more threads may especially be provided with a plurality of turns, such as intertwined curves. Thusly the one or more threads may face the support, especially the second face of the support. The frame structure may facilitate the one or more threads being in thermal contact with the second face of the support. Hence the frame structure may provide homogenization of thermal energy across the support. In addition to facing the second face of the support, the one or more threads may in specific embodiments face the first face of the support. Thereby the one or more threads may further be in thermal contact with the first face of the support. Such configuration may provide further homogenization of thermal energy across the support. Therefore, in embodiments, one or more threads are configured in one or more openings, wherein the one or more threads are configured in thermal contact with the second face.

Hence, in specific embodiments, the support may comprise a first face and a second face, wherein the plurality of electrical components are configured at the first face, wherein the electronic arrangement further comprises a frame structure, configured at the second face; wherein the frame structure comprises a structural element, further comprising one or more openings facing the support, wherein one or more threads are configured in one or more openings; and wherein the one or more threads are configured in thermal contact with the second face.

In particular, the one or more threads with a (rock or fluff) wool character may be configured in thermal contact with one or more electrical components functionally coupled to the support and positioned at the first face. The one or more wool threads may be configured to at least partially cover the one or more electrical components. Especially, in embodiments with a plurality of electrical components, the one or more wool threads may be configured between the plurality of electrical components. Further, the one or more (rock)wool threads may be configured in thermal contact with the plurality of electrical components. Thereby, the one or more threads with a wool character may facilitate homogenization of thermal energy from the electrical components throughout the wool structure.

Especially, in the present invention, the one or more threads may additionally be configured in thermal contact with the PCB. Especially, the one or more threads may be configured in thermal contact with one or more of the electrical components coupled to the PCB. Further, the one or more threads may (by definition) be configured in thermal contact with ambient air. Hence, the one or more threads may guide heat away from critical parts of the PCB. Thus in embodiments, one or more threads are configured in thermal contact with the printed circuit board.

In further embodiments, the electrical arrangement and the thermal exchange material may be enclosed by an arrangement enclosure. The arrangement enclosure may at least partly enclose the electrical arrangement and the thermal exchange material. Especially, the arrangement enclosure may (essentially) entirely enclose the electrical arrangement and the thermal exchange material. In specific embodiments, one or more of the (one or more threads) may also be in thermal contact with the arrangement enclosure. Therefore in embodiments, the electronic arrangement further comprises an arrangement enclosure enclosing the electrical arrangement and the thermal exchange material, wherein one or more threads are configured in thermal contact with the arrangement enclosure. For instance, the arrangement of the arrangement enclosure with the electrical arrangement and thermal exchange material may comprise a housing for a driver (for e.g. a light generating device (see also below). The arrangement enclosure may also be indicated as first housing. The one or more threads with a (rock or fluff) wool character may be configured to at least partially fill up the (first) housing. Especially, the one or more threads with a wool character may be configured to (essentially) fill up the entire (first) housing.

Moreover, the electronic arrangement may further comprise a heat sink, heat spreader or (other) two-phase cooling device. The one or threads may be configured in thermal contact with the heat sink, heat spreader, or (other) two-phase cooling device, in addition to being in thermal contact with one or more electrical components. Thereby, heat may be guided away from the one or more electrical components through the one or more threads towards the heat sink, heat spreader, or (other) two-phase cooling device. Hence, in embodiments, the electronic arrangement further comprises a heat sink (heat spreader, or (other) two-phase cooling device), wherein one or more threads are configured in thermal contact with the heat sink (heat spreader, or (other) two-phase cooling device).

In another aspect, the invention provides a light generating system comprising a light generating device. In embodiments, the light generating device may be configured to generate device light. The light generating system may in embodiments, further comprise a (second) housing, wherein the housing may comprise an end window via which device light may be outcoupled. The light generating system may be configured to generate system light, wherein system light may comprise the device light. Especially, the system light may escape via the end window. Further, in embodiments, the light generating system may comprise a control system. In embodiments, the control system may especially be used to control the operation of the light generating system. The light generating device may in embodiments be electrically connected to the electronic arrangement. Especially, the support may be electrically coupled to the light generating device by means of electrical wiring. Hence, in specific embodiments, the invention provides a light generating system comprising a control system, a light generating device and the electronic arrangement, wherein the support is electrically coupled to the light generating device (by means of electrical wiring), wherein the light generating device is configured to generate device light, wherein the light generating system is configured to generate system light, wherein system light comprises device light, wherein the light generating system comprises an end window, wherein the system light escapes the via the end window, and wherein the control system is configured to control the light generating device. Such system may comprise a second housing enclosing the first housing. The first housing may in embodiments host a control system or driver for the light generating device.

Yet, in embodiments the invention provides a light generating system comprising a light generating device and the electronic arrangement as defined herein, wherein the electronic arrangement may be functionally coupled to the light generating device. Especially, the electronic arrangement may be electrically coupled to the light generating device. The light generating device may comprise a light source. The term "light source" may in principle relate to any light source known in the art.

In embodiments, the light generating device may comprise a light source, especially a solid state light source. Especially, the electronic arrangement may be functionally coupled to the light generating device. In embodiments, the electronic arrangement may be configured as driver or controller for the light generating device. Hence, in specific embodiments, the invention provides a light generating system comprising a light generating device and the electronic arrangement, wherein the light generating device comprises a solid state light source, wherein the electronic arrangement is functionally coupled to the light generating device, and wherein the electronic arrangement is configured as driver or controller for the light generating device.

In embodiments, the solid state light source may comprise one or more of a light emitting diode, a laser diode, and a superluminescent diode. The term "light source" may also relate to a plurality of light sources, such as 2-2000 (solid state) LED light sources. Hence, the term LED may also refer to a plurality of LEDs.

The light generating system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, digital projection, or LCD backlighting. The light generating system (or luminaire) may be part of or may be applied in e.g. optical communication systems or disinfection systems.

In particular, embodiments of the invention may provide a sustainable light generating system, for example a sustainable LED light generating system. Such a light generating system may comprise sustainable materials, i.e., materials that may be obtained and manufactured with a relatively low (negative) impact on natural resources and the natural environment. Further, such a light generating system may comprise recyclable materials, i.e., materials that may be recycled into further products after use as part of the light generating system. Especially, the thermal exchange material described herein may be a sustainable and recyclable alternative to typical thermal potting materials and thermal interface materials.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc.. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions from a remote control. In embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface or with an optical sensor (e.g. QR code reader) of the (unique) code. The lighting system may also comprise means for communicating with other systems or devices, such as on the basis of Bluetooth, WIFI, LiFi, ZigBee, BLE or WiMAX, or another wireless technology.

The system, or apparatus, or device may execute an action in a "mode" or "operation mode" or "mode of operation" or "operational mode". The term "operational mode may also be indicated as "controlling mode". Likewise, in a method an action or stage, or step may be executed in a "mode" or "operation mode" or "mode of operation" or "operational mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, which can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing. In yet a further aspect, the invention also provides a projection device comprising the light generating system as defined herein. Especially, a projection device or "projector" or "image projector" may be an optical device that projects an image (or moving images) onto a surface, such as e.g. a projection screen. The projection device may include one or more light generating systems such as described herein. Hence, in an aspect the invention also provides a light generating device selected from the group of a lamp, a luminaire, a projector device, a disinfection device, a photochemical reactor, and an optical wireless communication device, comprising the light generating system as defined herein. The light generating device may comprise a housing or a carrier, configured to house or support, one or more elements of the light generating system.

Instead of the terms "lighting device" or "lighting system", and similar terms, also the terms "light generating device" or "light generating system", (and similar terms), may be applied. A lighting device or a lighting system may be configured to generate device light (or "lighting device light") or system light ("or lighting system light"). As indicated above, the terms light and radiation may interchangeably be used.

In a further aspect, the invention provides a method of assembly of the electronic arrangement as described herein. The method may in general comprise assembling the electrical arrangement and the thermal exchange material. Especially, the method may comprise configuring the one or more threads to be in thermal contact with at least one of the electrical components. Such configurations of the one or more threads have been described above. Further, the method may comprise configuring the one or more threads to be in thermal contact with another part, such as ambient air, the enclosure arrangement, or a part of the electrical arrangement. Hence, in specific embodiments, the invention may provide a method of assembly of the electronic arrangement comprising assembling the electrical arrangement and the thermal exchange material, such that one or more of the one or more threads are configured in thermal contact with at least one of the electrical components, to provide the arrangement.

In some embodiments, the one or more threads may have a rope-type character. Especially, the one or more rope-type threads may be wound around the electrical arrangement. The method of assembly may comprise winding the one or more rope-type threads around the electrical arrangement. In particular, the method of assembly may comprise winding the one or more rope-type threads around the electrical arrangement such that the one or more rope-type threads are in thermal contact with one or more electrical components. The method of assembly may further comprise winding the one or more rope-type threads around the electrical arrangement a plurality of times. In specific embodiments, the one or more rope-type threads may be wound around the electrical arrangement in different directions such that the one or more rope-type threads are in thermal contact with a different subset of electrical components for at least two of the plurality of times.

In other embodiments, the one or more threads may have a (rock or fluff) wool-type character. Especially, the one or more wool-type threads may be configured facing the second face of the support. The method of assembly may comprise arranging the one or more wool-type threads to the second face of the support. Alternatively or additionally, the method of assembly may comprise arranging the one or more wool-type threads to the side of the first face of the support such that the one or more wool-type threads are in thermal contact with one or more electrical components. The method of assembly may further comprise filling at least part of the (first) housing (see also above) with the one or more wool-type threads, such as filling (essentially) the (void space of the) entire (first) housing with the one or more wool-type threads. The void space may especially be the space enclosed by the (first) housing not occupied by electrical arrangement.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Fig. 1 schematically depicts a top-view and bottom-view of the electronic arrangement.
Fig. 2 schematically depicts the electronic arrangement comprising a frame structure.
Fig. 3A-B schematically depict configurations of the thermal exchange material.
Fig. 4 shows the cross-section of the light generating system.
Fig. 5 schematically depicts embodiments of the lighting device comprising the light generating system.

The schematic drawings are not necessarily to scale.

### DETAILED DESCRIPTION OF THE EMBODIMENTS

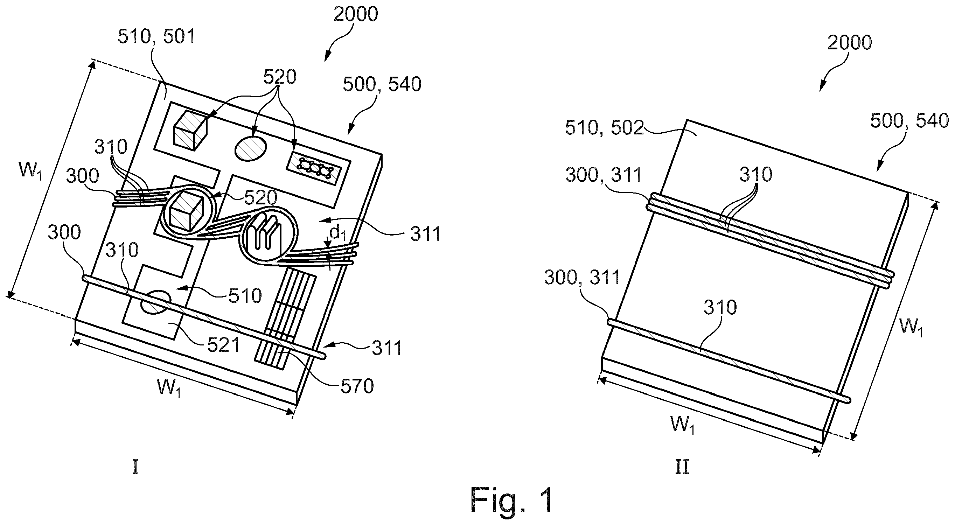

Fig. 1 schematically depicts an embodiment of the electronic arrangement 2000. The electronic arrangement 2000 comprises an electrical arrangement 500 and a thermal exchange material 300. The electrical arrangement 500 comprises a support 510 and a plurality of electrical components 520 supported by the support 510. The thermal exchange material 300 comprises one or more threads 310. The one or more threads 310 comprise a thermally conductive fibrous material 311. The thermally conductive fibrous material 311 comprises ultra-high-molecular-weight polyethylene (UHMWPE) fibrous material, though other materials may also be possible, see also above. One or more of the one or more threads 310 are configured in thermal contact with at least one of the electrical components 520.

Especially, the support 510 may comprise a first face 501 and a second face 502. The plurality of electrical components 520 are configured at the first face 501. Embodiment (I) depicts the support 510 seen at the first face 501 as a top-view. Embodiment (II) depicts the support 510 seen at the second face 502 as a bottom-view.

In Fig. 1A-B, at least one of the one or more threads 310 is wound around the electrical arrangement 500.

In the depicted embodiment, at least one other of the one or more threads 310 may be wound a plurality of times around the electrical arrangement 500.

Further, the following applies: one or more threads 310 are configured between two or more electrical components 520, and are in thermal contact with one or more electrical components 520.

Moreover, one or more threads 310 may have a thread diameter d1 selected from the range of 0.01 - 10 mm.

Furthermore, the thermally conductive fibrous material 311 may comprise polyethylene polymer chains with a molecular weight selected from the range of 1E6 - 1E7 Da. The thermally conductive fibrous material 311 may comprise polyethylene polymer chains having a fiber orientation selected from the range of 75 - 95%. The thermally conductive fibrous material 311 may comprise polyethylene polymer chains having a fiber diameter selected from the range of 0.98 - 1E6 nm, especially from the range of 2E3 - 5E4 nm. The thermally conductive fibrous material 311 may comprise polyethylene polymer chains having an (in-plane) thermal conductivity selected from the range of 10 - 30 W/mK. The thermally conductive fibrous material 311 may comprise polyethylene polymer chains having a density selected from the range of 0.5 - 5 g/cm³.

In the depicted embodiment, the support 510 may comprise a printed circuit board 540. The electrical components 520 are electrically coupled to the printed circuit board 540. One or more threads 310 are additionally configured in thermal contact with the printed circuit board 540 and with one or more electrical components 520.

The printed circuit board 540 as depicted may comprise an electrical track 521 functionally coupled to the electrical components 520.

The electronic arrangement 2000 may be depicted further comprising a heat sink 570. One or more threads 310 are configured in thermal contact with the heat sink 570.

Moreover, one or more of the electrical components 520 in thermal contact with one or more threads 310 are selected from the group comprising a capacitor, an inductor, a voltage regulator, an amplifier circuit, an integrated circuit, a central processing unit, a microprocessor unit, a power transistor, a field-effect transistor (especially a metal-oxide semiconductor field-effect transistor), a transformer, a resistor, a diode, and a sensor.

The support 510 may be further defined by a width W₁ and a length L₁. The width of the support 510 may be selected from the range of 5-200 mm, such as 5-50 mm. The length of the support 510 may be selected from the range of 20-2000 mm, such as 20-1500 mm. The support 510 may additionally have a height (not depicted) selected from the range of 0.2-10 mm, such as 0.5-5 mm, like 1-2 mm. Other dimensions may be possible as well in other embodiments.

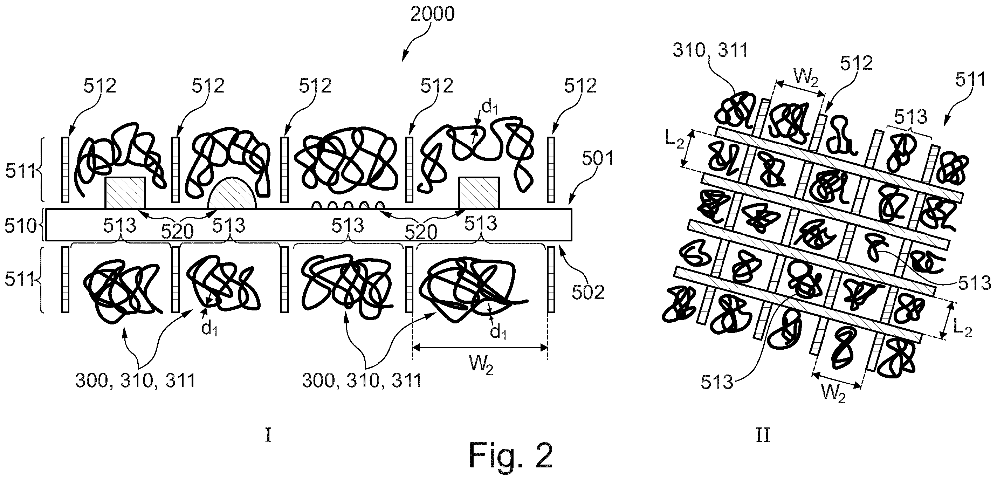

Fig. 2 schematically depicts, in a cross-sectional view, an embodiment the electronic arrangement 2000 comprising a frame structure 511. The frame structure 511 may be configured at the second face 502. In specific embodiments, the frame structure 511 may support the support 510. The frame structure 511 may comprise a structural element 512 further comprising one or more (through) openings 513 facing the support 510. One or more threads 310 are configured in one or more of the one or more (through) openings 513. The one or more threads 310 are configured in thermal contact with the second face 502, as well as the first face 501.

Embodiment (I) depicts a cross-section view of the electronic arrangement 2000. In embodiments of the present invention, the frame structure 511 may especially face the second face 502. In this embodiment, another frame structure 511 is - by way of optional embodiment - additionally configured at the first face 501. In another embodiment, one or more threads 310 with a (fluff or rock) wool-type character may be configured at the first face 501 without a frame structure 511.

Thereby the one or more threads 310 of thermally conductive fibrous material 311 comprised by the thermal exchange material 300 are configured in thermal contact with the second face 502 and the first face 501.In the present depiction, for the sake of clarity the one or more threads 310 are not depicted in direct contact (or physical contact) with the one or more electrical components 520. In general, to achieve thermal contact, the one or more threads 310 may especially be in direct contact with the one or more electrical components 520.

Embodiment (II) specifically depicts an embodiment of a bottom-view of the frame structure 511. In the depicted embodiment, each of the openings 513 may be filled with one or more threads 310. In other embodiments, a subset of the openings 513 may be filled with one or more threads 310.

Further, the following applies: one or more threads 310 cover at least part of one or more electrical components 520 and are in thermal contact with these one or more electrical components 520.

Moreover, one or more threads 310 are provided with a plurality of turns 311. The turns 311 comprise intertwined curves. One or more threads 310 may have thread diameters d1 selected from the range of 0.01 - 0.5 mm.

The openings 513 may be defined by a width W₂ and a length L₂. The width may especially be selected from the range of 1 - 100 mm. The length may further be selected from the range of 1 - 100 mm.

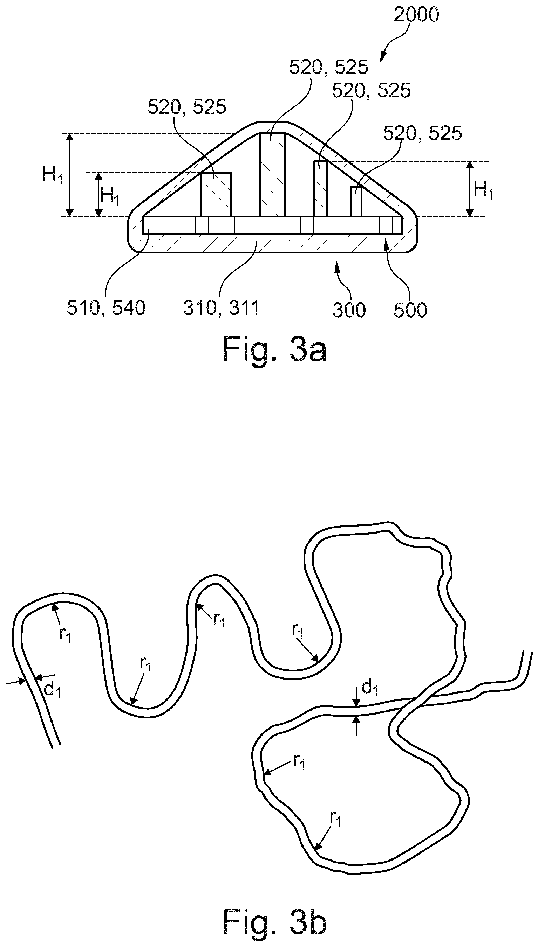

Fig. 3A-B schematically depict embodiments configurations of the thermal exchange material 300. Fig. 3A specifically depicts a cross-sectional view of the thermal exchange material 300 configured on an electronic arrangement 2000. Fig. 3B depicts a view of the one or more threads 310 of the thermal exchange material 300.

Fig. 3A depicts a cross-sectional view of the thermal exchange material 300 configured on an electronic arrangement 2000. At least one of the one or more threads 310 may be wound around the electrical arrangement 500.

Further, the electronic arrangement 2000 may comprise at least three electrical components 520. A subset 525 of the at least three electrical components 520 may comprise at least three electrical components 520. The electrical components 520 of the subset 525 are configured such that at least one thread 310 wound at least one time around the electrical arrangement 500 may be configured in thermal contact with all the electrical components 520 of the subset 525.

Furthermore, the following applies: one or more threads 310 cover at least part of one or more electrical components 520 and are in thermal contact with these one or more electrical components 520.

Specifically, the subset 525 of at least three electrical components 520 may be functionally coupled to PCB 540.

The at least three electrical components 520 of the subset 525 may have a height H₁ starting from the support 510. The at least three electrical components 520 of the subset 525 may have different heights H₁. The one or more threads 310 are wound around the electronic arrangement 2000 to cover the at least three electrical components 520 of the subset 525 with different heights H₁.

Hence, the PCB 540 with electrical components 520 may be designed such that a plurality of components may be in contact with the same thread 310. For instance, higher components may be configured in the middle of the PCB and smaller components more to the periphery of the PCB.

Fig. 3B depicts a view of the one or more threads 310 of the thermal exchange material 300. Herein one or more threads 310 are provided with a plurality of turns 311. The turns 311 comprise intertwined curves. One or more threads 310 may have thread diameters d1 selected from the range of 0.01 - 0.5 mm. The turns 311 may have radii r₁ selected from the range of d1 -18 mm.

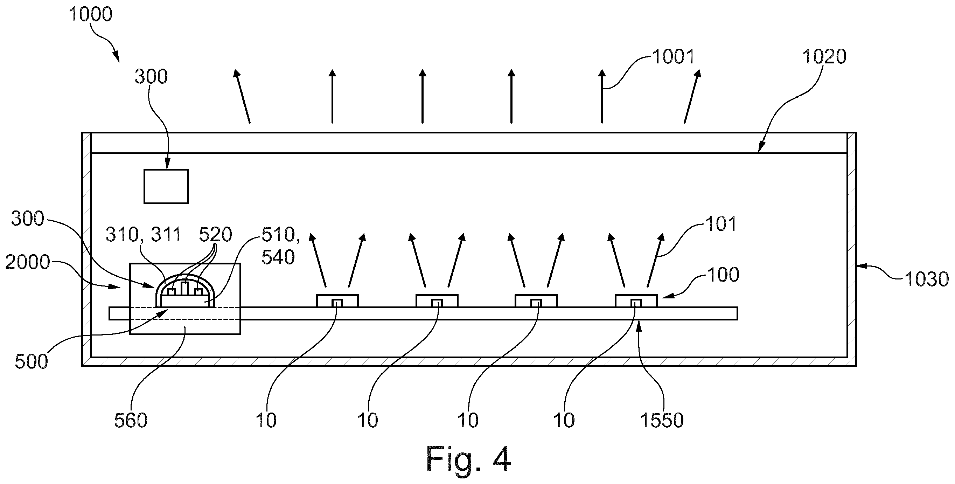

Fig. 4 shows the cross-section of the light generating system 1000. As mentioned before, in an aspect, the invention provides the light generating system 1000 comprising the electronic arrangement 2000. The light generating system 1000 may comprise a light generating device 100. In embodiments, the light generating device 100 may comprise a (solid state) light source 10. Especially, the electronic arrangement 2000 may be functionally coupled to the light generating device 100. In embodiments, the electronic arrangement 2000 may be configured as driver or controller for the light generating device 100(s). Especially, the (solid state) light source 10 may comprise one or more of a light emitting diode and a laser diode. More especially, the solid state light source may comprise a superluminescent diode.

In embodiments, the light generating system 1000 may be configured to generate system light 1001. Especially, the system light 1001 may comprise the device light 101. Further, in embodiments, the light generating system 1000 may comprise a housing 1030. Especially, the support 1550 may be (functionally) coupled to the housing 1030 or the housing 1030 may comprise the support 1550. In embodiments, the light generating device 100 may be electrically coupled to the support 1550, wherein the light generating devices 100 are configured on the part of the support 1550 that extends outside the arrangement enclosure 560. In such embodiments as depicted, the electronic arrangement 2000 further may comprise an arrangement enclosure 560 enclosing the electrical arrangement 500 and the thermal exchange material 300, wherein one or more threads 310 of the thermally conductive fibrous material 311 are configured in thermal contact with (i) one or more of the electrical components 520 supported by a support 540, especially a PCB 540, and (ii) the arrangement enclosure 560.

In embodiments, the housing 1030 may comprise one or more walls and an exit window 1020. Especially, the exit window 1020 may be configured downstream of the one or more light generating devices 100. More especially, the electronic arrangement 2000 may be configured to provide system light 1001 via the exit window 1020. The terms "upstream" and "downstream" relate to an arrangement of items or features relative to the propagation of the light from a light generating means (here the especially the light source), wherein relative to a first position within a beam of light from the light generating means, a second position in the beam of light closer to the light generating means may be "upstream", and a third position within the beam of light further away from the light generating means may be "downstream".

In the embodiment depicted, the light generating devices 100 may generate device light 101. The system light 1001 may especially comprise the device light 101 and may escape via the exit window 1020.

Furthermore, the light generating system 1000 may comprise a control system 300. Especially, the control system 300 may be configured to control the light generating device 100.

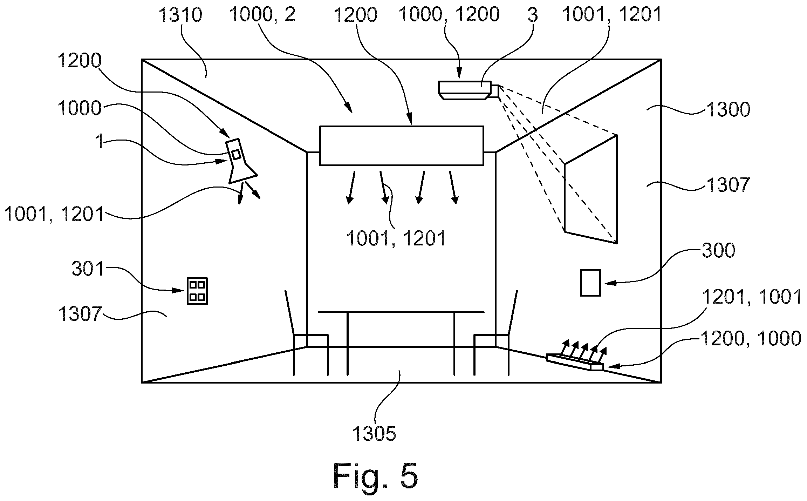

Fig. 5 schematically depicts embodiments of a luminaire 2 comprising the light generating system 1000 as described above. Reference 301 indicates a user interface which may be functionally coupled with the control system 300 comprised by or functionally coupled to the light generating system 1000. Hence, Fig. 5 schematically depicts embodiments of a lighting device 1200 selected from the group of a lamp 1, a luminaire 2, a projector device 3, a disinfection device, a photochemical reactor, and an optical wireless communication device, comprising the light generating system 1000 as described herein. In embodiments, such lighting device may be a lamp 1, a luminaire 2, a projector device 3, a disinfection device, or an optical wireless communication device. Lighting device light escaping from the lighting device 1200 may be indicated with reference 1201. Lighting device light 1201 may essentially consist of system light 1001, and may in specific embodiments thus be system light 1001. In embodiments, the light generating device 1200 may be configured provide system light 1001 on one or more surfaces in a room 1300. Especially, the light generating system 1000 may illuminate the walls 1307, or the floor 1305, or the ceiling 1310 in a room 1300.

Thermal simulation experiments were carried out on electrical arrangements 500 comprising a PCB 540 functionally coupled to one or more electrical components 520. The one or more electrical components 520 were configured in thermal contact with: (i) one or more threads 310 of the thermally conductive fibrous material 311 as the thermal exchange material 310 of the present invention, or (ii) typical thermal potting materials or thermal interface materials as control material. Temperatures of the one or more electrical components 520 on the electrical arrangement 500 were measured and compared between the typical thermal potting materials or thermal interface materials and the thermal exchange material 310.

The results of thermal simulation experiments carried out on four electrical components 520 in thermal contact with the one or more threads 310 configured as rope-type threads demonstrated an average decrease of 0.33 °C in temperature across the four electrical components compared to the same four electrical components 520 in thermal contact with control material.

Further, the results of thermal simulation experiments carried out on three electrical components 520 on the second face 502 of a support 510 in thermal contact with the one or more threads 310 configured as wool-type threads demonstrated an average decrease of 1.68 °C in temperature across the three electrical components compared to the same three electrical components 520 in thermal contact with control material.

Moreover, the results of thermal simulation experiments carried out on two electrical components 520 on the first face 501 of a support 510 in thermal contact with the one or more threads 310 configured as wool-type threads demonstrated an average decrease of 1.36 °C in temperature across the two electrical components compared to the same two electrical components 520 in thermal contact with control material.

Together, these experiments demonstrated that the thermal exchange material 310 described herein may lead to a decrease in temperature of one or more electrical components 520 ranging from 0.33 - 3.06 °C. Especially, the use of rope-type threads 310 may facilitate a decrease in temperature in one or more specific electrical components 520. The use of wool-type threads may facilitate homogenization of a decrease in temperature across an electrical arrangement 500. Such a decrease may result in an increased lifespan and performance from the one or more electrical components 520.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" also includes embodiments wherein the term "comprises" means "consists of".

The term "and/or" especially relates to one or more of the items mentioned before and after "and/or". For instance, a phrase "item 1 and/or item 2" and similar phrases may relate to one or more of item 1 and item 2. The term "comprising" may in embodiments refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage. In yet a further aspect, the invention (thus) provides a software product, which, when running on a computer is capable of bringing about (one or more embodiments of) the method as described herein.

The disclosure also provides a control system that may control the device, apparatus, or system, or that may execute the herein described method or process. Yet further, the disclosure also provides a computer program product, when running on a computer which is functionally coupled to or comprised by the device, apparatus, or system, controls one or more controllable elements of such device, apparatus, or system.

The various aspects discussed in this patent can be combined in order to provide additional advantages. Further, the person skilled in the art will understand that embodiments can be combined, and that also more than two embodiments can be combined. Furthermore, some of the features can form the basis for one or more divisional applications.

## Claims

1. An electronic arrangement (2000) comprising an electrical arrangement (500) and a thermal exchange material (300); wherein the electrical arrangement (500) comprises a support (510) and a plurality of electrical components (520) supported by the support (510); wherein the thermal exchange material (300) comprises one or more threads (310), wherein the one or more threads (310) comprise a thermally conductive fibrous material (311), wherein the thermally conductive fibrous material (311) comprises ultra-high-molecular-weight polyethylene fibrous material; and wherein one or more of the one or more threads (310) are configured in thermal contact with at least one of the electrical components (520),
wherein at least one of the one or more threads (310) is wound around the electrical arrangement (500).

2. The electronic arrangement (2000) according to claim 1, wherein at least one of the one or more threads (310) is wound a plurality of times around the electrical arrangement (500).

3. The electronic arrangement (2000) according to any of the preceding claims, wherein one or more of the following applies: (i) one or more threads (310) cover at least part of one or more electrical components (520) and are in thermal contact with these one or more electrical components (520), and (ii) one or more threads (310) are configured between two or more electrical components (520), and are in thermal contact with one or more electrical components (520).

4. The electronic arrangement (2000) according to any of the preceding claims, comprising at least three electrical components (520), wherein a subset (525) of the at least three electrical components (520) comprises at least three electrical components (520), wherein the electrical components (520) of the subset (525) are configured such that at least one thread (310) wound at least one time around the electrical arrangement (500) is configured in thermal contact with all the electrical components (520) of the subset (525).

5. The electronic arrangement (2000) according to any of the preceding claims, wherein one or more threads (310) have a thread diameter (d1) selected from the range of 0.01 - 10 mm.

6. The electronic arrangement (2000) according to any one of the preceding claims 1-5, wherein one or more threads (310) are provided with a plurality of turns (311), wherein one or more threads (310) have thread diameters (d1) selected from the range of 0.01 - 0.5 mm, and wherein the turns (311) have radii (r1) selected from the range of d1 -18 mm.

7. The electronic arrangement (2000) according to claim 5, wherein the support (510) comprises a first face (501) and a second face (502), wherein the plurality of electrical components (520) are configured at the first face (501), wherein the electronic arrangement (2000) further comprises a frame structure (511), configured at the second face (502); wherein the frame structure (511) comprises a structural element (512), further comprising one or more openings (513) facing the support (510), wherein one or more threads (310) are configured in one or more openings (513); and wherein the one or more threads (310) are configured in thermal contact with the second face (502).

8. The electronic arrangement (2000) according to any one of the preceding claims, wherein the thermally conductive fibrous material (311) comprises polyethylene polymer chains with a molecular weight selected from the range of 1E6 - 1E7 Da, having a fiber orientation selected from the range of 75 - 95%, having a fiber diameter selected from the range of 0.98 - 1E6 nm, having a thermal conductivity selected from the range of 10 - 30 W/mK, and having a density selected from the range of 0.5 - 5 g/cm³.

9. The electronic arrangement (2000) according to any one of the preceding claims, wherein the support (510) comprises a printed circuit board (540), wherein the electrical components (520) are electrically coupled to the printed circuit board (540); wherein one or more threads (310) are configured in thermal contact with the printed circuit board (540).

10. The electronic arrangement (2000) according to any one of the preceding claims, further comprising an arrangement enclosure (560) enclosing the electrical arrangement (500) and the thermal exchange material (300), wherein one or more threads (310) are configured in thermal contact with the arrangement enclosure (560).

11. The electronic arrangement (2000) according to any one of the preceding claims, further comprising a heat sink (570), wherein one or more threads (310) are configured in thermal contact with the heat sink (570).

12. The electronic arrangement (2000) according to any one of the preceding claims, wherein one or more of the electrical components (520) are selected from the group comprising a capacitor, an inductor, a voltage regulator, an amplifier circuit, an integrated circuit, a central processing unit, a microprocessor unit, a power transistor, a field-effect transistor, a transformer, a resistor, a diode, and a sensor.

13. A light generating system (1000) comprising (i) a light generating device (100) and (ii) the electronic arrangement (2000) according to any one of the preceding claims, wherein the light generating device (100) comprises a solid state light source, wherein the arrangement (2000) is functionally coupled to the light generating device (100), and wherein the arrangement (2000) is configured as driver or controller for the light generating device (100).

14. A method of assembly of the electronic arrangement (2000) according to any one of the preceding claims 1-12, comprising: assembling the electrical arrangement (500) and the thermal exchange material (300), such that one or more of the one or more threads (310) are configured in thermal contact with at least one of the electrical components (520), to provide the arrangement (2000).

## Patentansprüche

1. Elektronische Anordnung (2000), die eine elektrische Anordnung (500) und ein Wärmeaustauschmaterial (300) umfasst; wobei die elektrische Anordnung (500) eine Halterung (510) und eine Vielzahl von elektrischen Komponenten (520) umfasst, die durch die Halterung (510) getragen werden; wobei das Wärmeaustauschmaterial (300) einen oder mehrere Fäden (310) umfasst, wobei der eine oder die mehreren Fäden (310) ein wärmeleitfähiges Fasermaterial (311) umfassen, wobei das wärmeleitfähige Fasermaterial (311) Fasermaterial aus Polyethylen mit ultrahoher Molekülmasse umfasst; und wobei einer oder mehrere des einen oder der mehreren Fäden (310) in thermischem Kontakt mit mindestens einer der elektrischen Komponenten (520) konfiguriert sind,
wobei mindestens einer des einen oder der mehreren Fäden (310) um die elektrische Anordnung (500) gewickelt ist.

2. Elektronische Anordnung (2000) nach Anspruch 1, wobei mindestens einer des einen oder der mehreren Fäden (310) eine Vielzahl von Malen mehrfach um die elektrische Anordnung (500) gewickelt ist.

3. Elektronische Anordnung (2000) nach einem der vorstehenden Ansprüche, wobei eines oder mehrere des Folgenden gilt: (i) ein oder mehrere Fäden (310) bedecken mindestens einen Teil einer oder mehrerer elektrischer Komponenten (520) und stehen in thermischem Kontakt mit dieser einen oder diesen mehreren elektrischen Komponenten (520), und (ii) ein oder mehrere Fäden (310) sind zwischen zwei oder mehr elektrischen Komponenten (520) konfiguriert und stehen in thermischem Kontakt mit einer oder mehreren elektrischen Komponenten (520).

4. Elektronische Anordnung (2000) nach einem der vorstehenden Ansprüche, die mindestens drei elektrische Komponenten (520) umfasst, wobei eine Teilmenge (525) der mindestens drei elektrischen Komponenten (520) mindestens drei elektrische Komponenten (520) umfasst, wobei die elektrischen Komponenten (520) der Teilmenge (525) so konfiguriert sind, dass mindestens ein Faden (310), der mindestens einmal um die elektrische Anordnung (500) gewickelt ist, in thermischem Kontakt mit allen elektrischen Komponenten (520) der Teilmenge (525) konfiguriert ist.

5. Elektronische Anordnung (2000) nach einem der vorstehenden Ansprüche, wobei ein oder mehrere Fäden (310) einen Fadendurchmesser (d1) aufweisen, der aus dem Bereich von 0,01 bis 10 mm ausgewählt ist.

6. Elektronische Anordnung (2000) nach einem der vorangehenden Ansprüche 1 bis 5, wobei ein oder mehrere Fäden (310) mit einer Vielzahl von Windungen (311) bereitgestellt sind, wobei ein oder mehrere Fäden (310) Fadendurchmesser (d1) aufweisen, die aus dem Bereich von 0,01 bis 0,5 mm ausgewählt sind, und wobei die Windungen (311) Radien (r1) aufweisen, die aus dem Bereich von d1 bis 18 mm ausgewählt sind.

7. Elektronische Anordnung (2000) nach Anspruch 5, wobei die Halterung (510) eine erste Fläche (501) und eine zweite Fläche (502) umfasst, wobei die Vielzahl von elektrischen Komponenten (520) an der ersten Fläche (501) konfiguriert sind wobei die elektronische Anordnung (2000) ferner eine Rahmenstruktur (511) umfasst, die an der zweiten Fläche (502) konfiguriert ist;
wobei die Rahmenstruktur (511) ein Strukturelement (512) umfasst, das ferner eine oder mehrere Öffnungen (513) umfasst, die der Halterung (510) zugewandt sind, wobei ein oder mehrere Fäden (310) in einer oder mehreren Öffnungen (513) konfiguriert sind; und wobei der eine oder die mehreren Fäden (310) in thermischem Kontakt mit der zweiten Fläche (502) konfiguriert sind.

8. Elektronische Anordnung (2000) nach einem der vorstehenden Ansprüche, wobei das wärmeleitfähige Fasermaterial (311) Polyethylenpolymerketten umfasst, die eine Molekülmasse aufweisen, die aus dem Bereich von 1E6 bis 1E7 Da ausgewählt ist, eine Faserausrichtung aufweisen, die aus dem Bereich 75 bis 95 % ausgewählt ist, einen Faserdurchmesser aufweisen, der aus dem Bereich von 0,98 bis 1E6 nm ausgewählt ist, eine Wärmeleitfähigkeit aufweisen, die aus dem Bereich von 10 bis 30 W/mK ausgewählt ist, und eine Dichte aufweisen, die aus dem Bereich von 0,5 bis 5 g/cm³ ausgewählt ist.

9. Elektronische Anordnung (2000) nach einem der vorstehenden Ansprüche, wobei die Halterung (510) eine Leiterplatte (540) umfasst, wobei die elektrischen Komponenten (520) elektrisch mit der Leiterplatte (540) gekoppelt sind; wobei ein oder mehrere Fäden (310) in thermischem Kontakt mit der Leiterplatte (540) konfiguriert sind.

10. Elektronische Anordnung (2000) nach einem der vorstehenden Ansprüche, die ferner ein Anordnungsgehäuse (560) umfasst, das die elektrische Anordnung (500) und das Wärmeaustauschmaterial (300) umschließt, wobei ein oder mehrere Fäden (310) in thermischem Kontakt mit dem Anordnungsgehäuse (560) konfiguriert sind.

11. Elektronische Anordnung (2000) nach einem der vorstehenden Ansprüche, die ferner einen Kühlkörper (570) umfasst, wobei ein oder mehrere Fäden (310) in thermischem Kontakt mit dem Kühlkörper (570) konfiguriert sind.

12. Elektronische Anordnung (2000) nach einem der vorstehenden Ansprüche, wobei eine oder mehrere der elektrischen Komponenten (520) aus der Gruppe ausgewählt sind, die einen Kondensator, eine Induktivität, einen Spannungsregler, eine Verstärkerschaltung, eine integrierte Schaltung, eine Zentraleinheit, eine Mikroprozessoreinheit, einen Leistungstransistor, einen Feldeffekttransistor, einen Transformator, einen Widerstand, eine Diode und einen Sensor umfasst.

13. Lichterzeugungssystem (1000), das (i) eine Lichterzeugungsvorrichtung (100) und (ii) die elektronische Anordnung (2000) nach einem der vorstehenden Ansprüche umfasst, wobei die Lichterzeugungsvorrichtung (100) eine Festkörperlichtquelle umfasst, wobei die Anordnung (2000) funktionell mit der Lichterzeugungsvorrichtung (100) gekoppelt ist und wobei die Anordnung (2000) als Treiber oder Steuerungseinheit für die Lichterzeugungsvorrichtung (100) konfiguriert ist.

14. Verfahren zur Montage der elektronischen Anordnung (2000) nach einem der vorstehenden Ansprüche 1 bis 12, umfassend: Montieren der elektrischen Anordnung (500) und des Wärmeaustauschmaterials (300), sodass einer oder mehrere des einen oder der mehreren Fäden (310) in thermischem Kontakt mit mindestens einer der elektrischen Komponenten (520) konfiguriert sind, um die Anordnung (2000) bereitzustellen.

## Revendications

1. Agencement électronique (2000) comprenant un agencement électrique (500) et un matériau d'échange thermique (300) ; dans lequel l'agencement électrique (500) comprend un support (510) et une pluralité de composants électriques (520) supportés par le support (510) ; dans lequel le matériau d'échange thermique (300) comprend un ou des fils (310), dans lequel le ou les fils (310) comprennent un matériau fibreux thermoconducteur (311), dans lequel le matériau fibreux thermoconducteur (311) comprend un matériau fibreux en polyéthylène de masse molaire ultra-élevée ; et dans lequel un ou plusieurs parmi le ou les fils (310) sont conçus de façon à venir en contact thermique avec au moins l'un des composants électriques (520),
dans lequel au moins l'un parmi le ou les fils (310) est enroulé autour de l'agencement électrique (500).

2. Agencement électronique (2000) selon la revendication 1, dans lequel au moins l'un parmi le ou les fils (310) est enroulé une pluralité de fois autour de l'agencement électrique (500).

3. Agencement électronique (2000) selon l'une quelconque des revendications précédentes, dans lequel un ou plusieurs parmi ce qui suit s'applique : (i) un ou plusieurs fils (310) recouvrent au moins une partie d'un ou de plusieurs composants électriques (520) et sont en contact thermique avec ce ou ces composants électriques (520), et (ii) un ou des fils (310) sont conçus entre deux ou plusieurs composants électriques (520), et sont en contact thermique avec un ou des composants électriques (520).

4. Agencement électronique (2000) selon l'une quelconque des revendications précédentes, comprenant au moins trois composants électriques (520), dans lequel un sous-ensemble (525) des au moins trois composants électriques (520) comprend au moins trois composants électriques (520), dans lequel les composants électriques (520) du sous-ensemble (525) sont conçus de telle sorte qu'au moins un fil (310) enroulé au moins une fois autour de l'agencement électrique (500) est conçu de façon à être en contact thermique avec tous les composants électriques (520) du sous-ensemble (525).

5. Agencement électronique (2000) selon l'une quelconque des revendications précédentes, dans lequel un ou des fils (310) présentent un diamètre de fil (d1) choisi dans la plage de 0,01 à 10 mm.

6. Agencement électronique (2000) selon l'une quelconque des revendications 1 à 5 précédentes, dans lequel un ou des fils (310) sont pourvus d'une pluralité de spires (311), dans lequel un ou des fils (310) présentent des diamètres de fil (d1) choisis dans la plage de 0,01 à 0,5 mm, et dans lequel les spires (311) présentent des rayons (r1) choisis dans la plage de d1 à 18 mm.

7. Agencement électronique (2000) selon la revendication 5, dans lequel le support (510) comprend une première face (501) et une seconde face (502), dans lequel la pluralité de composants électriques (520) sont réalisés au niveau de la première face (501), dans lequel l'agencement électronique (2000) comprend en outre une structure de cadre (511) réalisée au niveau de la seconde face (502) ;
dans lequel la structure de cadre (511) comprend un élément structurel (512), comprenant en outre une ou plusieurs ouvertures (513) faisant face au support (510), dans lequel un ou des fils (310) sont conçus dans une ou des ouvertures (513) ; et dans lequel le ou les fils (310) sont conçus de façon à être en contact thermique avec la seconde face (502).

8. Agencement électronique (2000) selon l'une quelconque des revendications précédentes, dans lequel le matériau fibreux thermoconducteur (311) comprend des chaînes polymères de polyéthylène ayant une masse moléculaire choisie dans la plage de 1E6 à 1E7 Da, présentant une orientation de fibre choisie dans la plage de 75 à 95 %, présentant un diamètre de fibre choisi dans la plage de 0,98 à 1E6 nm, présentant une conductivité thermique comprise dans la plage de 10 à 30 W/mK et présentant une densité choisie dans la plage de 0,5 à 5 g/cm³.

9. Agencement électronique (2000) selon l'une quelconque des revendications précédentes, dans lequel le support (510) comprend une carte de circuit imprimé (540), dans lequel les composants électriques (520) sont couplés électriquement à la carte de circuit imprimé (540) ; dans lequel un ou des fils (310) sont conçus de façon à être en contact thermique avec la carte de circuit imprimé (540).

10. Agencement électronique (2000) selon l'une quelconque des revendications précédentes, comprenant en outre une enceinte d'agencement (560) renfermant l'agencement électrique (500) et le matériau d'échange thermique (300), dans lequel un ou des fils (310) sont conçus de façon à être en contact thermique avec l'enceinte d'agencement (560).

11. Agencement électronique (2000) selon l'une quelconque des revendications précédentes, comprenant en outre un dissipateur thermique (570), dans lequel un ou des fils (310) sont conçus de façon à être en contact thermique avec le dissipateur thermique (570).

12. Agencement électronique (2000) selon l'une quelconque des revendications précédentes, dans lequel un ou plusieurs des composants électriques (520) sont choisis dans le groupe comprenant un condensateur, inducteur, régulateur de tension, circuit amplificateur, circuit intégré, unité centrale, unité à microprocesseur, transistor de puissance, transistor à effet de champ, transformateur, résistor, diode et capteur.

13. Système générateur de lumière (1000) comprenant (i) un dispositif générateur de lumière (100) et (ii) l'agencement électronique (2000) selon l'une quelconque des revendications précédentes, dans lequel le dispositif générateur de lumière (100) comprend une source de lumière à semi-conducteurs, dans lequel l'agencement (2000) est couplé fonctionnellement au dispositif générateur de lumière (100), et dans lequel l'agencement (2000) est configuré en guise de pilote ou de contrôleur pour le dispositif générateur de lumière (100).

14. Procédé d'assemblage de l'agencement électronique (2000) selon l'une quelconque des revendications précédentes 1 à 12, comprenant : l'assemblage de l'agencement électrique (500) et du matériau d'échange thermique (300), de telle sorte qu'un ou plusieurs parmi le ou les fils (310) sont conçus de façon à être en contact thermique avec au moins l'un des composants électriques (520), pour obtenir l'agencement (2000).
